# EUROPEAN PATENT APPLICATION

(11) **EP 3 290 775 A1**
(43) Date of publication of application: **07.03.2018**
(21) Application number: 17158616.7
(22) Date of filing: 01.03.2017
(51) Int. Cl.: F21S 8/10

(54) **VEHICLE LIGHTING DEVICE AND VEHICLE LAMP**

(30) Priority: 30.08.2016 JP 2016167862
(71) Applicant: Toshiba Lighting & Technology Corporation, Yokosuka-shi, Kanagawa-ken 237-8510 (JP)
(72) Inventor: MATSUDA, Yohei, Kanagawa 237-8510 (JP); TSUCHIYA, Ryuji, Kanagawa 237-8510 (JP); KOSUGI, Daisuke, Kanagawa 237-8510 (JP)
(74) Representative: Awapatent AB

(57) **Abstract**

According to one embodiment, a vehicle lighting device includes a base body that has a plate shape and includes a first portion, and a second portion having a width dimension smaller than a width dimension of the first portion; a wiring pattern that is provided on surfaces of the first portion and the second portion; and a light emitting element that is electrically connected to the wiring pattern provided in the first portion.

## Description

### FIELD

Embodiments described herein relate generally to a vehicle lighting device and a vehicle lamp.

### BACKGROUND

A wedge base bulb having no mouthpiece is used as a vehicle lighting device. The wedge base bulb is an incandescent bulb. Therefore, from viewpoints of power saving and long life, the wedge base bulb is replaced with a vehicle lighting device including light emitting diodes.

If the wedge base bulb is replaced with the vehicle lighting device including the light emitting diodes, it is preferable that a socket on which the wedge base bulb is mounted can be used as it is. Therefore, a lead portion of the vehicle lighting device including the light emitting diodes has the same shape and dimensions as those of the lead portion of the wedge base bulb.

In addition, vibration caused by running of a vehicle and vibration from an engine, and the like are added to the vehicle lighting device. Therefore, if a force for holding the vehicle lighting device is weak, there is a concern that the vehicle lighting device falls out of the socket. Therefore, a technique, in which a terminal having a projection portion is provided in a socket and a recessed portion suitable for the projection portion provided in the terminal is provided in a lead portion of the vehicle lighting device, is proposed.

However, if external dimensions and a shape of the vehicle lighting device including the light emitting diodes are matched with external dimensions and a shape of the wedge base bulb, there is a problem that a configuration becomes complicated and a manufacturing cost increases.

Therefore, it is desired to develop a vehicle lighting device which can reduce a manufacturing cost and a vehicle lam p.

### DESCRIPTION OF THE DRAWINGS

FIG. 1 is a schematic sectional view illustrating a vehicle lighting device and a vehicle lamp according to an embodiment.
FIGS. 2A to 2C are schematic views illustrating the vehicle lighting device.
FIGS. 3A to 3D are schematic views illustrating a second holding portion according to another embodiment.
FIG. 4 is a schematic view illustrating a second holding portion according to still another embodiment.
FIG. 5 is a schematic view illustrating a second holding portion according to still another embodiment.

### DETAILED DESCRIPTION

In general, according to one embodiment, a vehicle lighting device according to the embodiment includes a base body that has a plate shape and includes a first portion, and a second portion having a width dimension smaller than a width dimension of the first portion; a wiring pattern that is provided on surfaces of the first portion and the second portion; and a light emitting element that is electrically connected to the wiring pattern provided in the first portion.

Hereinafter, exemplary embodiments will be described with reference to the drawings. Moreover, the same reference numerals are given to the same configuration elements in each drawing and detailed description will be appropriately omitted.

As a vehicle lighting device 1 according to the embodiment, for example, a room lam p, a meter lam p, a reading lamp, a brake lamp, a direction indicator lamp, a tail lamp, and the like provided in an automobile, a railroad car, or the like can be exemplified. However, the use of the vehicle lighting device 1 is not limited to the examples.

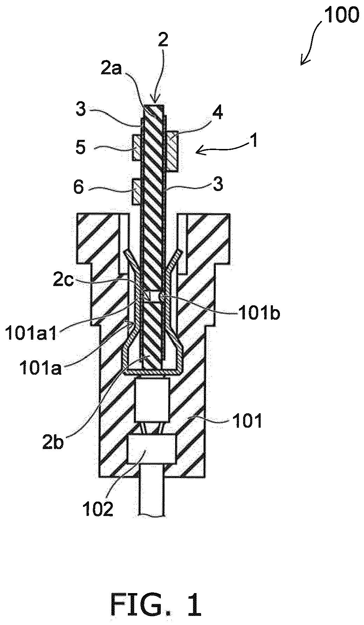

FIG. 1 is a schematic sectional view illustrating the vehicle lighting device 1 and a vehicle lamp 100 according to an embodiment.

As illustrated in FIG. 1, the vehicle lam p 100 is provided with a socket 101, a wiring 102, and the vehicle lighting device 1.

The socket 101 has a space into which the vehicle lighting device 1 is inserted on an inside thereof. The socket 101 can be, for example, a cylindrical body of which one end portion is opened. However, a shape or a size of the socket 101 is not limited to the example and can be appropriately changed according to a use or a size of the vehicle lamp 100, or the like.

The socket 101 can be formed of, for example, an insulating material. The socket 101 can be formed of, for example, urea resin or the like.

The space of the socket 101 into which the vehicle lighting device 1 is inserted is provided with a pair of terminals 101a. That is, the socket 101 is provided with two terminals 101a having a U-shape. The pair of terminals 101a are provided side by side in a width direction of a second portion 2b of a base body 2. One terminal 101a is connected to a plus side of an external power supply via the wiring 102. The other terminal 101a is connected to a minus side of the external power supply via the wiring 102. The pair of terminals 101a are formed of a material having conductivity and elasticity. The pair of terminals 101a can be formed of, for example, copper alloy such as beryllium copper.

When the vehicle lighting device 1 (second portion 2b of the base body 2) is inserted into the inside of the socket 101, the second portion 2b of the base body 2 is sandwiched between the pair of terminals 101a. Therefore, the vehicle lighting device 1 is held by the socket 101. I n addition, a wiring pattern 3 provided in the second portion 2b is in contact with the terminals 101a. Therefore, the external power supply and a light emitting element 4 can be electrically connected.

In addition, a first holding portion 101 b is provided on a surface of the terminal 101a on a side facing the base body 2. The first holding portion 101b can be provided in each of the pair of terminals 101a, or can be provided in one terminal 101a. I n addition, the first holding portion 101b can be provided in each of two contact portions 101a1, or can be provided in one contact portion 101a1 of the terminal 101a. A height of the first holding portion 101b is, for example, 0.25 mm, but is not particularly limited to the example.

When the vehicle lighting device 1 (second portion 2b) is inserted into the inside of the socket 101, the first holding portion 101b provided in the socket 101 is connected to a second holding portion 2c provided in the second portion 2b. Therefore, the vehicle lighting device 1 is held by the socket 101. In this way, even if vibration caused by running of a vehicle and vibration from an engine, and the like are added to the vehicle lamp 100, it is possible to prevent the vehicle lighting device 1 from falling out of the socket 101.

The first holding portion 101b can be integrally formed with the terminal 101a. The first holding portion 101b can be formed simultaneously with the terminal 101a, for example, when press-forming the terminal 101a. A shape of the first holding portion 101b is not particularly limited, but it is preferable that the shape of the first holding portion 101b is hard to be caught when inserting the vehicle lighting device 1 into the inside of the socket 101. The shape of the first holding portion 101b can be, for example, hemispherical or the like.

Moreover, in FIG. 1, the first holding portion 101b having a projection portion and the second holding portion 2c having an opening into which the first holding portion 101b is inserted are exemplified, but are not limited to the example. The second holding portion 2c having a projection portion and the first holding portion 101b having an opening into which the second holding portion 2c is inserted may be provided. That is, the first holding portion 101b and the second holding portion 2c may cooperate to hold the vehicle lighting device 1.

In addition, the number, size, and arrangement of the first holding portions 101b are not limited to the example, and can be appropriately changed according to the size and the use of the vehicle lamp 100, and the like.

One end portion of the wiring 102 is electrically connected to one pair of terminals 101a. The other end portion of the wiring 102 is electrically connected to the external power supply. Moreover, the wiring 102 is not necessarily required. For example, the pair of terminals 101a may be exposed on an end surface or an outer surface of the socket 101, and a connection terminal provided in a vehicle and the pair of terminals 101a may be electrically connected.

Next, the vehicle lighting device 1 according to the embodiment will be illustrated.

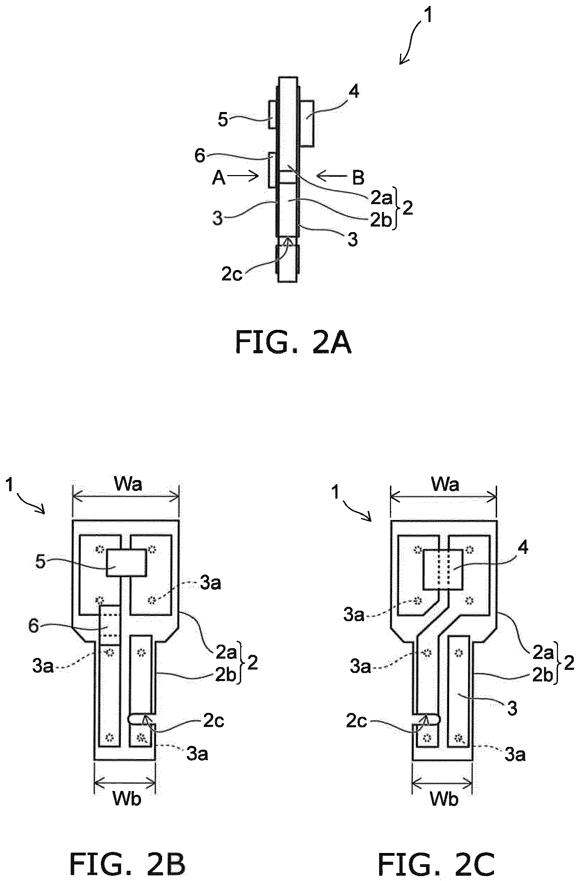

FIGS. 2A to 2C are schematic views illustrating the vehicle lighting device 1.

FIG. 2A is a side view of the vehicle lighting device 1.

FIG. 2B is a schematic plan view of the vehicle lighting device 1 viewed from direction A in FIG. 2A.

FIG. 2C is a schematic plan view of the vehicle lighting device 1 viewed from direction B in FIG. 2A.

As illustrated in FI GS. 2A to 2C, the vehicle lighting device 1 is provided with the base body 2, the wiring pattern 3, the light emitting element 4, a resistor 5, and a diode 6.

The base body 2 has a flat plate shape. The base body 2 has a first portion 2a and the second portion 2b. A width dimension Wb of the second portion 2b is smaller than a width dimension Wa of the first portion 2a. Moreover, the width dimension is a dimension in a direction orthogonal to a direction in which the vehicle lighting device 1 is inserted into the socket 101.

In order to facilitate replacement with a conventional wedge base bulb and the like, the width dimension Wa of the first portion 2a can be set to 30 mm or less, for example, to 7.6 mm. In addition, the width dimension Wb of the second portion 2b can be set to 20 mm or less, for example, to 4.4 mm. However, the width dimension Wa of the first portion 2a and the width dimension Wb of the second portion 2b are not particularly limited to the example, and can be appropriately changed. In addition, a tapered shape can be formed between the first portion 2a and the second portion 2b.

I n the wiring pattern 3 provided in the first portion 2a, the light emitting element 4, the resistor 5, and the diode 6 are electrically connected. The second portion 2b is inserted into the socket 101. The terminal 101a is in contact with the wiring pattern 3 provided in the second portion 2b. In addition, the second portion 2b is provided with the second holding portion 2c. The second holding portion 2c is provided at a position facing the first holding portion 101b when inserting the vehicle lighting device 1 into the inside of the socket 101.

If the first portion 2a having a long width dimension is provided, it is possible to increase a mounting area. Therefore, it is easy to change the number, size, arrangement of the light emitting element 4, the resistor 5, and the diode 6, and the like. In addition, if the first portion 2a having a long width dimension is provided, it is possible to hook a finger on the first portion 2a when attaching and detaching the vehicle lighting device 1. Therefore, attachment and detachment of the vehicle lighting device 1 to or from the socket 101 becomes easy. Moreover, although the base body 2 having a T-shaped planar shape is illustrated, it is not limited to the example. For example, the base body 2 having an L-shaped planar shape may be provided.

The base body 2 can be formed of an insulating material. The base body 2 can be formed of an inorganic material such as ceramics (for example, aluminum oxide or aluminum nitride), an organic material such as paper phenol or glass epoxy, or the like. In addition, the base body 2 may be one in which a surface of a metal plate is coated with an insulating material. Moreover, if the surface of the metal plate is coated with the insulating material, the insulating material may be made of an organic material or may be made of an inorganic material. A thickness of the base body 2 is 1.6 mm to 2.0 mm, in which the thickness thereof is, for example, 2.0 mm. However, the thickness of the base body 2 is not limited to the example and can be appropriately changed.

When an amount of heat generated by the light emitting element 4 is large, from the viewpoint of heat radiation, it is preferable to form the base body 2 using a material having high thermal conductivity. As the material having high thermal conductivity, for example, ceramics such as aluminum oxide and aluminum nitride, high thermal conductive resin, a material which is obtained by coating a surface of metal plate with an insulating material, and the like can be exemplified. The high thermal conductive resin is, for example, one that is obtained by mixing resin such as polyethylene terephthalate (PET) or nylon with a filler made of aluminum oxide or carbon having high thermal conductivity.

The wiring pattern 3 is provided on surfaces of the first portion 2a and the second portion 2b. The wiring pattern 3 can be provided on one surface of the base body 2, but it is preferable to provide on both surfaces of the base body 2. If the wiring pattern 3 is provided on the both surfaces of the base body 2, it is possible to increase the mounting area. In addition, since a contact area with the terminal 101a can be increased, it is possible to improve reliability about electric connection.

The wiring pattern 3 provided on one surface of the base body 2 and the wiring pattern 3 provided on the other surface of the base body 2 are electrically connected by a conductive via 3a passing through the base body 2 in a thickness direction.

In this case, when the light emitting element 4, the resistor 5, and the diode 6 are in electric contact with the wiring pattern 3, a shape of the wiring pattern 3 and an arrangement of the conductive via 3a are provided such that they are connected in series.

The wiring pattern 3 can be formed of a low resistance metal such as copper or aluminum.

The light emitting element 4 is provided on the surface of the first portion 2a. The light emitting element 4 can be disposed on a center axis of the first portion 2a in the width direction, but the disposition position is not particularly limited. The light emitting element 4 is electrically connected to the wiring pattern 3 provided on the surface of the first portion 2a. The light emitting element 4 can be, for example, a light emitting diode, an organic light emitting diode, a laser diode, or the like.

A current of the light emitting element 4 is, for example, 5 mA to 50 mA.

A form of the light emitting element 4 is not particularly limited.

The light emitting element 4 can be, for example, a surface mount type light emitting element such as a Plastic Leaded Chip Carrier (PLCC) type. Moreover, the light emitting element 4 illustrated in FIGS. 1, 2A, and 2C is the surface mount type light emitting element.

The light emitting element 4 can also be, for example, a light emitting element having lead wires such as shell type. In addition, the light emitting element 4 can also be mounted by a Chip On Board (COB). In a case of the light emitting element 4 that is mounted by the COB, the chip-shaped light emitting element 4, wiring that electrically connects the light emitting element 4 and the wiring pattern 3, a frame-like member surrounding the light emitting element 4 and wiring, a sealing portion that is provided on an inside of the frame-like member and covers the light emitting element 4 and wiring, and the like can be provided on the first portion 2a. In addition, the sealing portion can include a phosphor. The phosphor can be, for example, a YAG phosphor (yttrium aluminum garnet phosphor). A type of the phosphor is not limited to the example. The type of the phosphor can be appropriately changed so as to obtain a desired luminescent color according to the use of the vehicle lighting device 1, and the like.

A light emitting surface of the light emitting element 4 is substantially parallel to the surface of the base body 2. The light emitting element 4 mainly emits light in a direction perpendicular to the surface of the base body 2. When the light emitting element 4 is provided on one surface of the base body 2, the light has a biased light distribution characteristic. However, if the vehicle lighting device 1 is a passenger compartment lamp (for example, a room lamp, a meter lamp, a reading lamp, or the like), one side of the vehicle lighting device 1 may be irradiated with light. Therefore, if the vehicle lighting device 1 is the passenger compartment lamp, such a light distribution characteristic is preferable.

The number, size, and arrangement and the like of the light emitting elements 4 are not limited to the example, and can be appropriately changed according to the size and the use of the vehicle lighting device 1, and the like. For example, in FIGS. 1, 2A, and 2C, a case where the light emitting element 4 is provided on one surface of the first portion 2a is illustrated, but the light emitting elements 4 can also be provided on both surfaces of the first portion 2a. If the light emitting elements 4 are provided on the both surfaces of the first portion 2a, the vehicle lighting device 1 having a wide light distribution characteristic can be obtained. For example, if the vehicle lighting device 1 is a vehicle exterior lamp (for example, a brake lamp, a direction indicating lamp, a tail lamp, or the like), such a light distribution characteristic is preferable.

The resistor 5 can be provided on the surface of the first portion 2a. The resistor 5 can be provided on a surface of the first portion 2a on a side on which the light emitting element 4 is provided, but it is preferable that the resistor 5 is provided on a surface of the first portion 2a on a side opposite to a side on which the light emitting element 4 is provided. If the resistor 5 is provided on the surface of the first portion 2a on the side opposite to the side on which the light emitting element 4 is provided, it is possible to suppress that light emitted from the light emitting element 4 is absorbed by the resistor 5 or blocked by the resistor 5. In addition, since the mounting area can be increased, it is easy to increase the number of the light emitting element 4, the resistor 5, and the diode 6, or to reduce the size of the vehicle lighting device 1.

The resistor 5 is electrically connected to the wiring pattern 3 provided on the surface of the first portion 2a. The resistor 5 controls a current flowing through the light emitting element 4.

The resistor 5 can be a current limiting resistor.

In addition, the resistor 5 can also adjust a brightness of the light emitting element 4. Since a forward voltage characteristic of the light emitting element 4 varies, if an applied voltage between an anode terminal and a ground terminal is constant, variation occurs in the brightness (luminous flux, luminance, luminous intensity, illuminance) of the light emitting element 4. Therefore, a value of the current flowing through the light emitting element 4 is set within a predetermined range by the resistor 5 so that the brightness of the light emitting element 4 falls within a predetermined range. In this case, the value of the current flowing through the light emitting element 4 can fall within the predetermined range by changing a resistance value of the resistor 5.

The resistor 5 can be, for example, a surface mount type resistor, a resistor (metal oxide film resistor) having a lead wire, a film type resistor formed by a screen printing method, or the like. I n addition, the resistor 5 illustrated in FIGS. 1, 2A, and 2B is the surface mount type resistor.

The number, size, and arrangement of the resistors 5, and the like are not limited to the example, and can be appropriately changed according to the number and specification of the light emitting elements 4, and the like.

Moreover, a resistance value of the film type resistor can be easily adjusted. Therefore, if the adjustment of the resistance value is performed, it is preferable to form the film type resistor. In this case, the adjustment of the resistance value can be performed as follows. First, the film type resistor (resistor 5) is formed on the surface of the first portion 2a using the screen printing method or the like. Next, a part of the resistor 5 is removed by irradiating the resistor 5 with laser light. Therefore, the resistance value of the resistor 5 is changed depending on a size of a removed portion or the like. In this case, if a part of the resistor 5 is removed, the resistance value increases.

The diode 6 can be provided on the surface of the first portion 2a. The diode 6 can be provided on a surface of the first portion 2a on a side on which the light emitting element 4 is provided, but it is preferable to be provided on a surface on a side of the first portion 2a opposite to the side on which the light emitting element 4 is provided. If the diode 6 is provided on the surface on the side of the first portion 2a opposite to the side on which the light emitting element 4 is provided, it is possible to suppress that light emitted from the light emitting element 4 is absorbed by the diode 6 or blocked by the diode 6. In addition, since the mounting area can be increased, it is easy to increase the number of the light emitting element 4, the resistor 5, and the diode 6, or to reduce the size of the vehicle lighting device 1.

The diode 6 is electrically connected to the wiring pattern 3 provided on the surface of the first portion 2a. The diode 6 is provided to prevent a reverse voltage from being applied to the light emitting element 4 and to prevent pulse noise from a reverse direction from being applied to the light emitting element 4.

In addition, electric components such as a transistor, a capacitor, and an integrated circuit can be provided on the surface of the base body 2, if necessary.

I n addition, it is also possible to provide a cover portion for covering the wiring pattern 3, the film type resistor, or the like. The cover portion can be, for example, a film made of a white solder resist, a film made of a glass material, or the like.

Next, the first holding portion 101b and the second holding portion 2c will be described.

As illustrated in FIGS. 1, and 2A to 2C, the first holding portion 101b can be formed to have a projection shape. In addition, the second holding portion 2c can have an opening into which the first holding portion 101b is inserted. I n this case, the second holding portion 2c passes through the second portion 2b in the thickness direction and can also be opened to a side surface of the second portion 2b. That is, the second holding portion 2c can be a notch provided in the second portion 2b. The width of the second holding portion 2c (notch) is set to, for example, 0.5 mm to 0.8 mm, but is not particularly limited to the example.

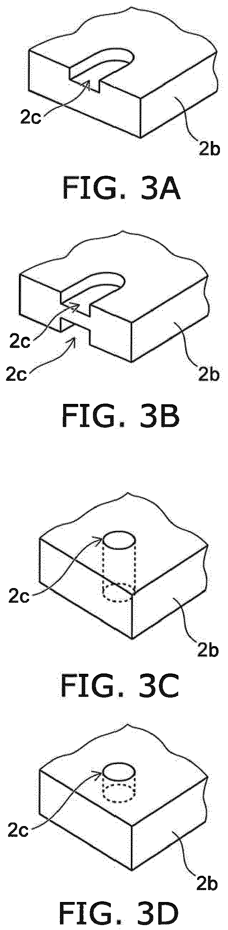

FIGS. 3A to 3D are schematic views illustrating a second holding portion 2c according to another embodiment.

As illustrated in FIG. 3A, the second holding portion 2c does not pass through a second portion 2b in a thickness direction and can be opened to one surface and a side surface of the second portion 2b.

As illustrated in FIG. 3B, the second holding portion 2c can be provided on both surfaces of the second portion 2b.

As illustrated in FIG. 3C, the second holding portion 2c can be a hole passing through the second portion 2b in the thickness direction.

As illustrated in FIG. 3D, the second holding portion 2c can be a recessed portion that does not pass through the second portion 2b in the thickness direction.

I n addition, since a first holding portion 101b is provided in a terminal 101a, the second holding portion 2c, which is opened to the surface of the second portion 2b on which a wiring pattern 3 is provided, is illustrated. If the first holding portion 101b is provided at a portion of the socket 101 facing the side surface of the second portion 2b, the second holding portion 2c that is opened to the side surface of the second portion 2b can be provided.

If the second holding portion 2c passing through the second portion 2b in the thickness direction is used, it is easy to form the second holding portion 2c. Therefore, it is possible to reduce the manufacturing cost.

On the other hand, if the second holding portion 2c that does not pass through the second portion 2b in the thickness direction is used, it is possible to suppress that a strength of the base body 2 (second portion 2b) is lowered. A depth of the second holding portion 2c in a direction of the base body 2 can be, for example, 0.1 mm or more, but is not particularly limited to the example.

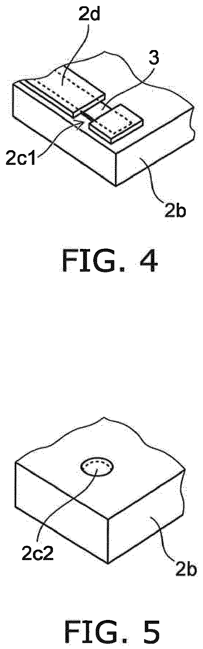

FIG. 4 is a schematic view illustrating a second holding portion 2c1 according to still another embodiment.

As illustrated in FIG. 4, the second holding portion 2c1 can be opened to a film portion 2d provided in the second portion 2b. If the film portion 2d is provided on the wiring pattern 3, the film portion 2d is formed of a conductive material. The film portion 2d can be formed, for example, of solder or the like. A width of the second holding portion 2c1 (opening of the film portion 2d) can be set to, for example, 0.5 mm to 0.8 mm, but is not particularly limited to the example.

I n this way, it is not necessary to process the base body 2 (second portion 2b) so that it is possible to reduce the manufacturing cost. In addition, it is possible to suppress that a strength of the base body 2 (second portion 2b) is lowered.

FIG. 5 is a schematic view illustrating a second holding portion 2c2 according to still another embodiment.

As illustrated in FIG. 5, the second holding portion 2c2 can be a projection-shaped body protruding from the second portion 2b. I n this case, the first holding portion 101b can be a hole provided in the terminal 101a.

The second holding portion 2c2 can be, for example, a round head screw (for example, a truss screw, a nave screw, and the like), a round head rivet, or the like.

In this way, the base body 2 (second portion 2b) can be easily processed so that it is possible to reduce the manufacturing cost. In addition, it is possible to suppress that a strength of the base body 2 (second portion 2b) is lowered.

As described above, the second holding portion may be connected to the first holding portion 101b provided in the socket 101 when inserting the second portion 2b into the socket 101.

According to the vehicle lighting device 1 of the embodiment, it is possible to simplify the configuration. Therefore, it is possible to greatly reduce the manufacturing coat.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions. Moreover, above-mentioned embodiments can be combined mutually and can be carried out.

## Claims

1. A vehicle lighting device (1) comprising:
a base body (2) that has a plate shape and includes a first portion (2a), and a second portion (2b) having a width dimension smaller than a width dimension of the first portion (2a);
a wiring pattern (3) that is provided on surfaces of the first portion (2a) and the second portion (2b); and
at least one light emitting element (4) that is electrically connected to the wiring pattern (3) provided in the first portion (2a).

2. The device (1) according to claim 1, further comprising:
a second holding portion (2c2) that is provided in the second portion (2b) and is connected to a first holding portion (2c1) provided in a socket (101) when the second portion (2b) is inserted into the socket (101).

3. A vehicle lamp (100) comprising:
the vehicle lighting device (1) according to claim 1 or 2; and
a socket (101) into which the second portion (2b) of the base body (2) provided in the vehicle lighting device (1) is inserted.

4. The lamp (100) according to claim 3,
wherein the socket (101) includes a terminal (101a) with which a wiring pattern (3) provided in the second portion (2b) is in contact; and a first holding portion (2c1) that is provided in the terminal (101a).
